# EUROPEAN PATENT APPLICATION

(11) **EP 2 658 287 A1**
(43) Date of publication of application: **30.10.2013**
(21) Application number: 11851199.7
(22) Date of filing: 24.11.2011
(51) Int. Cl.: H04R 17/10, H04R 3/00, H04R 17/00

(54) **OSCILLATOR DEVICE AND ELECTRONIC INSTRUMENT**

(30) Priority: 20.12.2010 JP 2010282662
(71) Applicant: NEC CASIO Mobile Communications, Ltd., Kawasaki-shi Kanagawa 211-8666 (JP)
(72) Inventor: ONISHI, Yasuharu, Kawasaki-shi, Kanagawa 211-8666 (JP); KURODA, Jun, Kawasaki-shi, Kanagawa 211-8666 (JP); KISHINAMI, Yuichiro, Kawasaki-shi, Kanagawa 211-8666 (JP); SATOU, Shigeo, Kawasaki-shi, Kanagawa 211-8666 (JP); MURATA, Yukio, Kawasaki-shi, Kanagawa 211-8666 (JP); KOMODA, Motoyoshi, Kawasaki-shi, Kanagawa 211-8666 (JP); KAWASHIMA, Nobuhiro, Kawasaki-shi, Kanagawa 211-8666 (JP); UCHIKAWA, Tatsuya, Kawasaki-shi, Kanagawa 211-8666 (JP)
(74) Representative: Vossius & Partner
(86) International application number: PCT/JP2011/006520
(87) International publication number: WO 2012/086124

(57) **Abstract**

Each of piezoelectric vibrators 110 includes an elastic member 112 and a piezoelectric element 111. The piezoelectric element 111 is attached to the elastic member 112. A supporting member 120 has an opening. A plurality of the piezoelectric vibrators 110 are arranged in the opening along a first direction. It is preferable that the plurality of piezoelectric vibrators 110 have the same fundamental resonance frequency. In addition, it is preferable that an arrangement pitch of the piezoelectric vibrators 110 is equal to or less than half the wavelength of the fundamental resonance frequency.

## Description

### TECHNICAL FIELD

The present invention relates to an oscillator device having a piezoelectric vibrator, and an electronic instrument using the oscillator device.

### BACKGROUND ART

In cellular phones, sound functions such as a video phone call, moving image reproduction, or a hands-free function are required to be enhanced. Accordingly, it is expected that electro-acoustic transducers that are made small and have a large volume level output high power without increasing the size of the electro-acoustic transducers. In addition, from the viewpoint of privacy protection, superdirective speakers capable of forming a sound field at only a specific position are also required. An example of a superdirective speaker, a parametric speaker that uses ultrasonic waves for carrier waves of a sound or the like to demodulate the ultrasonic waves by non-linearity in air has been developed.

At present, various types of electro-acoustic transducers described above have been proposed (for example, Patent Documents 1 and 2).

### RELATED DOCUMENT

### PATENT DOCUMENT

[Patent Document 1] PCT Japanese Patent Domestic Re-publication No. WO2008/142867
[Patent Document 2] Japanese Unexamined Patent Publication No. 11-331985

### DISCLOSURE OF THE INVENTION

When the directivity of ultrasonic waves is narrowed down, like a phased array method, a method is adapted in which a main beam is generated by composing the ultrasonic waves oscillated by changes of a timing from an array probe in which a plurality of fine ultrasonic wave vibrators are arranged. When the method is employed, it is necessary to arrange a plurality of piezoelectric vibrators in an array, and thus the size of an oscillator device increases.

The invention is contrived in view of such circumstances, and an object thereof is to provide a small-sized oscillator device having a high directivity and an electronic instrument using the oscillator device.

An oscillator device of the invention includes a plurality of piezoelectric vibrators of which each has an elastic member and a piezoelectric element attached to the elastic member, and a supporting member that supports the plurality of piezoelectric vibrators. The supporting member has an opening. The plurality of piezoelectric vibrators are arranged in the opening along a first direction.

A first electronic instrument of the invention has the oscillator device of the invention, and an oscillation driving unit that causes the oscillator device to output ultrasonic waves demodulated into sound waves of an audible zone.

A second electronic instrument of the invention has the oscillator device of the invention, an oscillation driving unit that causes the oscillator device to output ultrasonic waves, an ultrasonic wave detection unit that detects sound waves having the same frequency as the ultrasonic waves, and a distance measurement unit that measures a distance to an object to be measured on the basis of the detected ultrasonic waves.

According to the oscillator device of the invention, it is possible to increase the directivity of the oscillator device without increasing the size of the oscillator device.

### BRIEF DESCRIPTION OF THE DRAWINGS

The above-described objects, other objects, features and advantages will be further apparent from the preferred embodiments described below, and the accompanying drawings as follows.

FIG. 1 is a schematic plan view illustrating a structure of an electro-acoustic transducer which is an oscillator device according to an embodiment of the invention.
FIG. 2 is a schematic vertical cross-sectional front view illustrating structures of main parts of the electro-acoustic transducer.
FIG. 3 is a schematic vertical cross-sectional front view illustrating structures of main parts of an electro-acoustic transducer according to a modified example.
FIG. 4 is a diagram illustrating a configuration of an electronic instrument according to a modified example.

### DESCRIPTION OF EMBODIMENTS

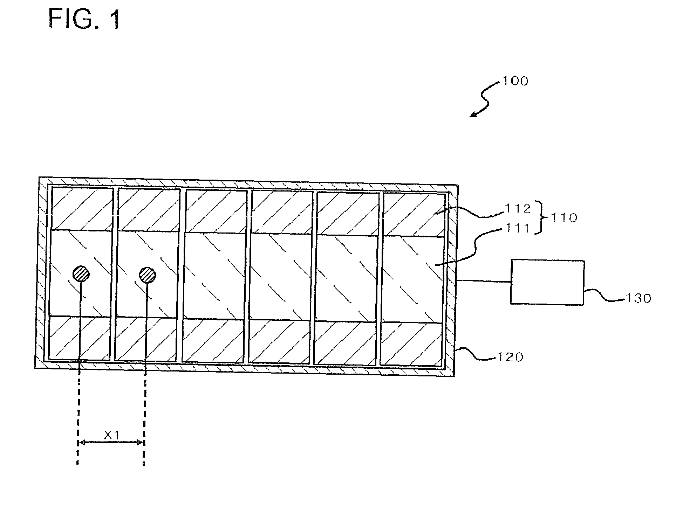

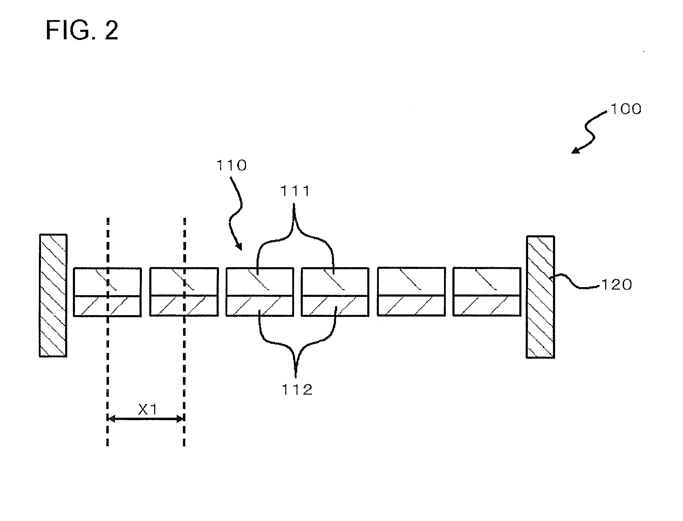

Hereinafter, an electro-acoustic transducer 100 which is an oscillator device of the embodiment will be described with reference to FIGS. 1 and 2. As illustrated in FIG. 1, the electro-acoustic transducer 100 of the embodiment has a plurality of piezoelectric vibrators 110 and a supporting member 120. Each of the piezoelectric vibrators 110 has an elastic member 112 and a piezoelectric element 111. The piezoelectric element 111 is attached to the elastic member 112. The supporting member 120 has an opening. The plurality of piezoelectric vibrators 110 are arranged in the opening along a first direction (horizontal direction in FIG. 1).

More specifically, the elastic member 112 has an elongate shape, for example, an oblong shape. The elastic member 112 is formed of, for example, phosphor bronze or stainless steel. The thickness of the elastic member 112 is preferably equal to or more than 5 µm and equal to or less than 500 µm. In addition, it is preferable that the elastic member 112 have a longitudinal elastic modulus, which is an index indicating stiffness, of equal to or more than 1 Gpa and equal to or less than 500 GPa.

The piezoelectric element 111 is disposed in the center of the elastic member 112 when seen in a plan view. The piezoelectric element 111 is formed of, for example, piezoelectric ceramic, but may be formed of an organic material having a piezoelectric property. A surface of the piezoelectric element 111 which faces the elastic member 112 is entirely constrained by the elastic member 112.

The exterior of the supporting member 120 has an oblong shape, and the opening has also an oblong shape. A beam or the like is not formed in the opening. A short side of the elastic member 112 is fixed to a lateral surface of a long side of the opening of the supporting member 120. In the example illustrated in the drawing, all the piezoelectric vibrators 110 positioned inside the opening are arranged in a row along the first direction.

Meanwhile, the plurality of piezoelectric vibrators 110 have the same fundamental resonance frequency. An arrangement pitch X1 of the plurality of piezoelectric vibrators 110 is equal to or less than half of the fundamental resonance frequency of the piezoelectric vibrators. The piezoelectric vibrators 110 are regularly arranged in such a manner that mutual vibrating surfaces do not overlap with each other in the supporting member 120 when seen in a plan view. In addition, a machine quality coefficient Q of the piezoelectric vibrator 110 is adjusted to equal to or more than 50.

In addition, the width of the piezoelectric vibrator 110 is the same as that of the elastic member 112. In other words, the piezoelectric vibrator 110 is positioned throughout the entire width in the center portion of the elastic member 112. Further, a driver circuit 130 is connected to the plurality of piezoelectric vibrators 110. The driver circuit 130 outputs sound waves by inputting oscillation signals to the piezoelectric vibrators 110. For example, the oscillation signal has the same frequency as the fundamental resonance frequency of the piezoelectric vibrator 110.

In detail, when the signal is input to the piezoelectric element 111 of the piezoelectric vibrator 110, the piezoelectric element 111 and the elastic member 112 move expansively and contractively. Sound waves are generated by the expansion and contraction vibration. The sound waves are, for example, ultrasonic waves having a frequency of 20 kHz or more. Since the piezoelectric element 111 has a high machine quality coefficient Q, energy is concentrated on the vicinity of a fundamental resonance frequency. Thus, a high sound pressure level can be obtained in the fundamental resonance frequency, but sound pressure attenuates in other frequency bands.

When the oscillator device is used as a parametric speaker, the oscillator device needs to oscillate ultrasonic waves limited to a specific frequency. Thus, there is an advantage in that the piezoelectric element 111 has the high machine quality coefficient Q. In addition, the fundamental resonance frequency of the piezoelectric vibrator 110 is influenced by the shape and size of the piezoelectric element 111. It is preferable to reduce the size of the piezoelectric element 111 in order to adjust a resonance frequency to a high frequency band, for example, an ultrasonic wave band. Thus, there is a tendency for a reduction in the size of the electro-acoustic transducer 100.

Meanwhile, when the oscillator device functions as a parametric speaker, the driver circuit 130 causes the piezoelectric vibrator 110 to oscillate ultrasonic waves on which, for example, FM (Frequency Modulation) or AM (Amplitude Modulation) is performed. The ultrasonic waves are demodulated into audible sounds by a non-linear state (sparse and dense state) of air.

When the oscillator device functions as a parametric speaker, the ultrasonic waves have a high straightness, and thus it is possible to form a sound field having super-directivity. Meanwhile, it is preferable to radiate sound waves from the plurality of piezoelectric vibrators 110 arranged in an array in order to control the directivity of the sound waves, like a phased array method. Even in the electro-acoustic transducer 100, the piezoelectric vibrators 110 are arranged in an one-dimensional array.

Hereinafter, operations and effects of the embodiment will be described. In the electro-acoustic transducer 100 of the embodiment, the plurality of piezoelectric vibrators 110 are arranged in the same opening provided in the supporting member 120 along the first direction. Thus, it is possible to bring the adjacent piezoelectric vibrators 110 close to each other. Accordingly, the phases of the sound waves oscillated from the adjacent piezoelectric vibrators 110 become opposite phases to each other, and thus it is possible to prevent the sound waves from canceling each other. Therefore, the directivity of the sound waves can be narrowed with high efficiency.

Particularly, in the embodiment, the piezoelectric element 111 is disposed in the center portion of the elastic member 112 in all the piezoelectric vibrators 110. The machine quality coefficient Q of the piezoelectric vibrator 110 is high. Thus, it is possible to cause portions that are most strongly radiating the sound waves in the piezoelectric vibrator 110 to be adjacent to each other. Therefore, the above-described effects become pronounced.

Meanwhile, when the driver circuit 130 drives the plurality of piezoelectric elements 111, the same driving signal may be input to all the piezoelectric elements 111, or driving signals to be input to the plurality of piezoelectric elements 111 may be individually controlled. In the latter case, the directivity of the sound waves can be finely controlled.

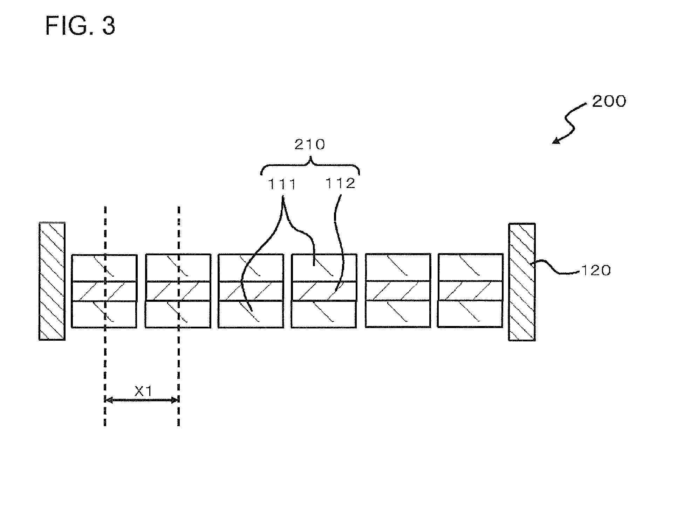

Meanwhile, the invention is not limited to the embodiments, and allows various modifications thereof without departing from the scope of the invention. For example, the piezoelectric vibrator 110 illustrated in FIG. 2 has a unimorph structure in which the piezoelectric element 111 is provided on only one surface of the elastic member 112. However, like an electro-acoustic transducer 200 illustrated in FIG. 3, a piezoelectric vibrator 210 having a bimorph structure in which the piezoelectric element 111 is provided on both surfaces of the elastic member 112 may be used. In this case, the output of the piezoelectric vibrator 110 can be increased.

In addition, in the above embodiments, it is assumed that the piezoelectric element 111 is constituted by one piezoelectric layer. However, the piezoelectric element 111 may have a layered structure in which a piezoelectric layer and an electrode layer are alternately stacked thereon (not shown).

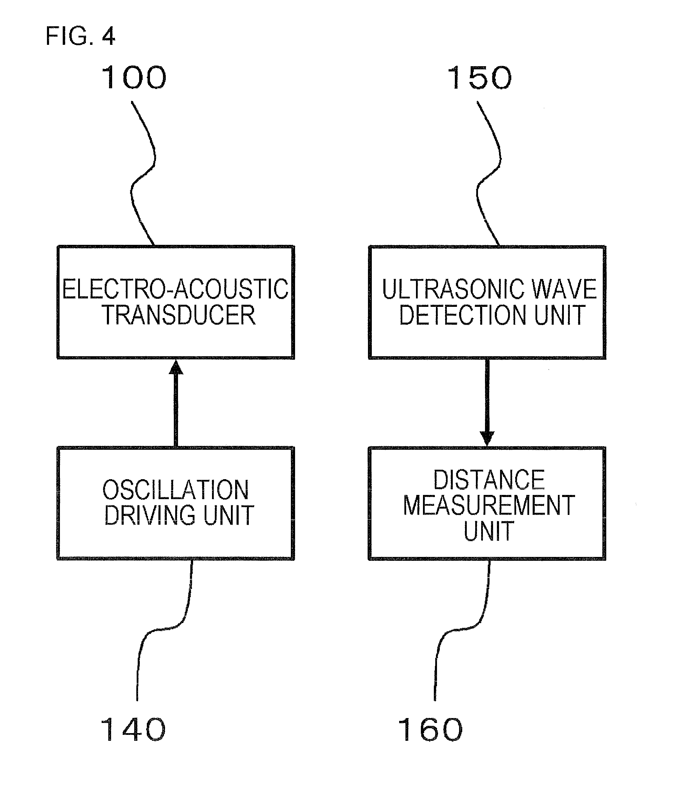

Further, in the electronic instrument according to the above embodiments, the driver circuit 130 for outputting an audible sound is connected to the electro-acoustic transducer 100. However, as illustrated in FIG. 4, the electronic instrument may be a sonar including the electro-acoustic transducer 100, an oscillation driving unit 140 that causes the electro-acoustic transducer 100 to output ultrasonic waves, an ultrasonic wave detection unit 150 that detects sound waves (for example, ultrasonic waves reflected by an object to be measured) having the same frequency as the ultrasonic waves oscillated from the electro-acoustic transducer 100, and a distance measurement unit 160 that measures a distance to the object to be measured on the basis of the detected ultrasonic waves.

Meanwhile, as a matter of course, the above-described embodiments and the above-described modified examples can be combined within a range in which contents thereof do not conflict with each other. Additionally, in the above-described embodiments and the above-described modified examples, a structure and the like of each component have been described in detail, but the structure can be changed in various ways within a range satisfying the invention.

The application claims the priority based on Japanese Patent Application No. 2010-282662 filed on December 20, 2010, the content of which is incorporated herein by reference.

## Claims

1. An oscillator device comprising:
a plurality of piezoelectric vibrators of which each has an elastic member and a piezoelectric element attached to the elastic member; and
a supporting member that supports the plurality of piezoelectric vibrators,
wherein the supporting member has an opening, and
wherein the plurality of piezoelectric vibrators are arranged in the opening along a first direction.

2. The oscillator device according to claim 1,
wherein the plurality of piezoelectric vibrators have the same fundamental resonance frequency, and
wherein an arrangement pitch of the piezoelectric vibrator is equal to or less than half the wavelength of the fundamental resonance frequency.

3. The oscillator device according to claim 1 or 2, wherein a machine quality coefficient Q of the piezoelectric vibrator is equal to or more than 50.

4. The oscillator device according to any one of claims 1 to 3, wherein the elastic member has an oblong shape, and two short sides of the oblong shape are supported by the supporting member.

5. The oscillator device according to any one of claims 1 to 4, wherein all the elastic members positioned inside the opening are arranged along the first direction.

6. The oscillator device according to any one of claims 1 to 5, wherein the piezoelectric vibrator has the piezoelectric element on each of both surfaces of the elastic member.

7. An electronic instrument comprising:
the oscillator device according to any one of claims 1 to 6; and
an oscillation driving unit that causes the oscillator device to output ultrasonic waves demodulated into sound waves of an audible zone.

8. An electronic instrument comprising:
the oscillator device according to any one of claims 1 to 6;
an oscillation driving unit that causes the oscillator device to output ultrasonic waves;
an ultrasonic wave detection unit that detects sound waves having the same frequency as the ultrasonic waves; and
a distance measurement unit that measures a distance to an object to be measured on the basis of the detected ultrasonic wave.
